(19) Europäisches Patentamt
European Patent Office
Office européen des brevets

(11) Publication number: **0 064 413**
**A1**

(12) # EUROPEAN PATENT APPLICATION

(21) Application number: 82302296.7

(51) Int. Cl.$^3$: G 01 R 27/04

(22) Date of filing: 05.05.82

(30) Priority: 05.05.81 GB 8113677

(43) Date of publication of application: 10.11.82 Bulletin 82/45

(84) Designated Contracting States: BE CH DE FR GB IT LI NL SE

(71) Applicant: GABRIEL MANUFACTURING COMPANY LIMITED
Newton Road
Torquay Devon TQ2 7HY(GB)

(72) Inventor: Botterell, Stanley William Henry
160 Dunstone View Plymstock
PlymouthDevon, PL9 8QL(GB)

(72) Inventor: Cooper, Michael Brian
39 Headland Park North Hill
Plymouth Devon(GB)

(74) Representative: Abbott, David John et al,
Abel & Imray Northumberland House 303-306 High Holborn
London, WC1V 7LH(GB)

(54) **Microwave impedance measurement apparatus.**

(57) Apparatus for measuring the impedance or another parameter of a device by reference to the standing wave pattern set up in a transmission line along which microwave energy is applied to the device. A section of the transmission line has three spaced probes from the output voltages of which corresponding digital values are produced and digital computing means calculates the impedance from the values. Calibrating measurements using a matched load and a short circuit instead of the device are performed earlier and the result representing probe sensitivities and energy wavelength used to simplify and speed up the calculations, so that a reasonably smooth display plot of the impedance with varying energy frequency can be produced in real time. The computing means has an 8-bit microprocessor for the handling and a 16-bit microprocessor to perform the calculations.

./...



Croydon Printing Company Ltd

COMPLETE DOCUMENT

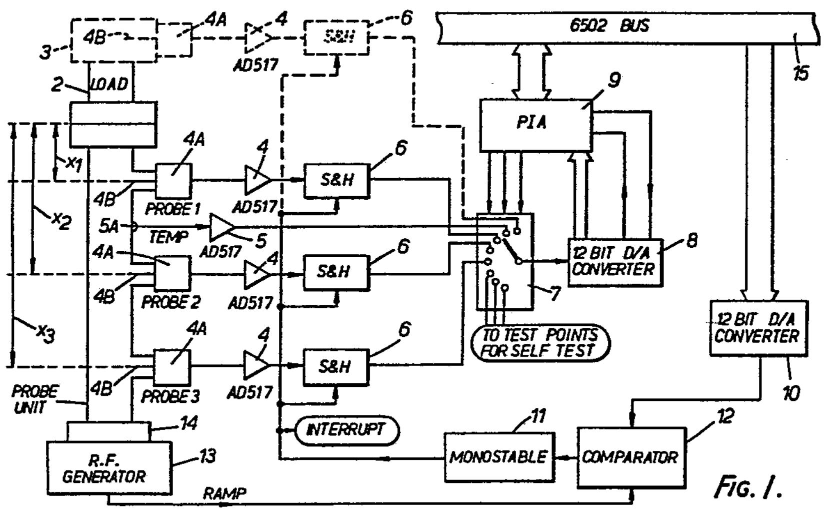

6502 BUS
15
PIA
9
12 BIT D/A CONVERTER
8
12 BIT D/A CONVERTER
10
4B
4A
4
AD517
S&H
6
3
2
LOAD
X1
X2
X3
PROBE 1
PROBE 2
PROBE 3
5A
TEMP
AD517
5
7
TO TEST POINTS FOR SELF TEST
PROBE UNIT
14
R.F. GENERATOR
13
RAMP
INTERRUPT
MONOSTABLE
11
COMPARATOR
12

FIG. 1.

This invention relates to apparatus for the measurement of the impedance of microwave networks or devices.

In the design, construction and adjustment of microwave networks or devices, it is necessary to assess the performance of the devices and one way of doing this is to measure the impedances of the networks or devices. Impedance measurement of a microwave device makes use of the standing wave pattern set up in a transmission line or waveguide along which microwave energy is applied to the device, and the theory and practice of this technique have been described for instance in chapter 8 of Volume II of the M.I.T. Radiation Laboratory Series, 1st Edition, published by McGraw-Hill. Originally a single sliding probe was employed to explore the standing wave pattern, but later three fixed probes spaced apart by one-eighth of the wavelength of the microwave signal in the transmission line were used as described, for example, in an article entitled "Check Impedance with an Electronic Slotted Line" by Norman Spector, pages 48 to 51 of Microwaves, September 1976. A difficulty with the methods described is that when the probe voltages have been measured it is then necessary to perform lengthy calculations before the actual value of the impedance can be known, with the result that the process of adjusting a microwave device for optimum performance can take a very long time. This time becomes even longer if the impedance is required at different frequencies.

It is an object of the present invention to reduce this difficulty enabling a display of the impedance value to be produced from the probe voltages within a relatively short time.

According to the present invention there is provided apparatus for measuring the impedance of a microwave device or a parameter related thereto by reference to the standing wave pattern set up in a transmission line along which microwave energy is applied to the device, the apparatus including an input for oscillations from a microwave oscillator, a section of transmission line for applying the oscillations to a device the impedance or other parameter of which is to be measured, a plurality of probes for sampling the microwave energy at respective spaced positions along the section of line and producing output voltages, a probe interface circuit connected to receive the output voltages from the probes and produce corresponding digital values therefrom, a digital signal processor circuit connected to receive the digital values as inputs from the probe interface circuit, the circuit being programmed to obtain calibration data representing the sensitivities of the probes and the wavelength of the microwave energy in the transmission line section and to calculate in response to the inputs the spacing of the probes and the calibration data the effective impedance of the device connected to the transmission line section, or data related to that impedance, as indicated by the phase and amplitude of a standing wave pattern set up in the section, the energy of which is sampled by the probes, and to generate output signals, and output means responsive to the output signals to produce a display representing the impedance or related parameters.

The signal processor circuit may include a microprocessor or computing means of greater size and complexity.

The apparatus may be calibrated by measuring the probe voltages when devices of known impedance are attached to the transmission line section. Conveniently, a device matched to the impedance of the transmission line section and a device short circuiting the transmission line section may be used. Since the efficiencies of the probes and the sensitivities of their associated R.F. detectors may vary slightly the use of a matched load on the transmission line section will enable the outputs of the probes to be normalised because the microwave energy level is the same at all places along the section. A short circuit on the transmission line section will produce total reflection of the R.F. energy so that a measure of the wavelength of the energy in the transmission line can be derived.

In addition, it has been found that the R.F. detectors are affected by changes in temperature, and therefore a temperature sensor may be provided on the transmission line section so that an input representing its temperature and consequently that of the detectors can be fed to the signal processor circuit to correct the outputs from the detectors. The correction required may be measured beforehand and stored in the signal processor circuit, for example in digital form in a read-only memory; a set of read-only memories respective to the detectors may be provided so that if a detector is changed the read-only memory can also be changed to maintain the calibration of the apparatus.

The oscillator connected to the apparatus may be of variable frequency and ramp generating means may be included or provided separately to cause the frequency of the oscillator to increase steadily or in steps over a range of values. The ramp generating means may be connected to the processor circuit so that the calculations performed can take into account the variation in oscillator frequency and the display can indicate the effect of change in frequency on the impedance of the device under test. The processor may be arranged to control the ramp generation or may follow it.

The spacing of the probes should be chosen relative to the wavelength of the RF energy in the transmission line section so that relatively large errors do not arise in the calculations. The probes themselves may be connected to the electric or magnetic field within the transmission line where appropriate or if the transmission line is a waveguide they may take the form of holes coupling the fields within the guide to, for example, strip-lines outside the guide. The probes have detectors which produce d.c. output signals. The probe interface circuit is arranged to perform the analogue to digital conversions so that digital inputs are fed to the signal processing circuit.

Where the device under test also has a microwave output the apparatus may include a further probe probe coupled to this output and interfaced to provide a further input to the processor circuit.

In general, the apparatus will include three probes along the section of transmission line, as this number of probes will enable three equations to be set up which can be solved readily for the unknowns as will be explained later. Certain calibration measurements are made to simplify the calculations required, but addition calibration measurements could enable the apparatus to function adequately with only two probes on the transmission line section.

The output means may include a cathode ray tube display device, a numerical display and/or a printer with a suitable interface for receiving, and storing if necessary, data from the processor circuit. The programming of the processor circuit may include the processing of the impedance data and/or other data related thereto to produce a display of a specific form from such as a Smith Chart. The data related to the impedance may be, for example, the reflexion coefficient and its phase. Alternatively, the transmission loss could be displayed as a function of frequency.

The microprocessor circuit could be arranged to calculate and store each point of the display as the osciallator frequency performs a single sweep throgh the range and build up the display as spots on a raster-scanned cathode ray tube progressively in synchronism with the frequency sweep. The display would need to be refreshed frequently from the stored display data. The stored data could represent picture elements of the display to be produced, and the data could also be fed to a dot-matrix printer. Alternatively, if the display is in the form of a linear graph similar to that of an oscilloscope, X,Y or r,θ deflection, the stored data could represent the coordinates of successive points along the line to be produced as the display, from which data deflection voltages for the cathode ray tube would be derived. Stored data of this latter form could be applied to a plotter if a printed output is required. It may be preferable for the oscillator frequency to be stepped rather than continuously varied through the range so that the different probe voltages relate to exactly the same frequency; this is on the assumption that the probe voltages are sampled or converted sequentially. Alternatively, the probe voltages may be sampled simultaneously and the conversion carried out on the sampled values. The processor circuit may provide signals for controlling the sweeping or stepping of the oscillator frequency or these signals may be generated by a separate clock which also produces a synchronising input for the processor circuit. Alternatively, as would be appropriate if the ramp generator were incorporated in the oscillator, a signal from the ramp generator could be applied to the processor to indicate to it the frequency of the oscillation being produced at the time. The control of the oscillator frequency could also be manual, in which case a corresponding voltage would be applied to the processor and the output could take the form of a single value display.

The processor circuit itself may include a first, 8-bit, microprocessor to perform the receiving of the data and the operations required to convert the output data in the desired format, and a second, 16-bit, processor to carry out the calculations on the data.

The programs and calibration data required for the calculations to be performed by the second processor may be stored in a read-only memory. Because of the shorter access time of semiconductor random access memories than that of read-only memories it may be desirable to transfer the data from the read-only memory to a random access memory to increase the speed of the caculations performed by the second processor.

In order that the invention may be fully understood and readily carried into effect an embodiment will now be described with reference to the accompanying drawings, of which:-

FIGURE 1 is a diagram of the probes and probe interface of one example of apparatus according to the invention;

FIGURE 2 is a diagram of the signal processor circuit of the example of the invention;

FIGUREs 3 & 4
show in more detail the circuit of the probe interface;

FIGURE 5 shows the circuit of a random access memory of the signal processor circuit of Figure 2;

FIGURE 6 shows the circuit of a read-only memory of the signal processor circuit of Figure 2; and

FIGUREs 7 & 8
show further parts of the circuit of Figure 2.

Before describing in detail the embodiment of the invention shown in the drawings, the form of the calculation of the impedance from the output voltages of the probes will be indicated, leading to the derivation of formulae suitable for determining the actual value of the impedance from the probe voltages by the processor circuit.

The distribution of voltage along a terminated transmission line resulting from an applied oscillation may be expressed in the form:-

$$V_x^2 = k\left[1 + P^2 + 2P.\cos(\theta - 2\beta.x)\right] \quad . . . . (1)$$

where

x is the distance along the line from a termination,

P is the ratio of the magnitudes of the waves reflected by and incident on the termination,

$\theta$ is the phase angle difference between the incident and reflected waves at the reference plane, i.e. the load, and

$\beta$ is $2\pi/\lambda_g$, where $\lambda_g$ is the wavelength of the oscillation along the transmission line and in some cases is assumed to be known.

In order to find the impedance of the termination it is necessary to calculate the values of $\rho$ and $\theta$, because from these the impedance can be determined, as follows:-

$$Z_L/Z_o = (1 + \rho.e^{i\theta})/(1 - \rho.e^{i\theta})$$

where

$Z_o$ is the characteristic impedance of the transmission line, and

$Z_L$ is the impedance of the termination.

For three probes producing voltages $V_1$, $V_2$ and $V_3$ and located at distances $x_1$, $x_2$ and $x_3$ from the termination, equation (1) becomes

$$V_1^2 = k[1 + \rho^2 + 2\rho.\cos(\theta - 2\beta.x_1)]$$

$$V_2^2 = k[1 + \rho^2 + 2\rho.\cos(\theta - 2\beta.x_2)]$$

$$V_3^2 = k[1 + \rho^2 + 2\rho.\cos(\theta - 2\beta.x_3)]$$

To carry out an analysis of an unknown termination, it will be necessary to find p, θ, k, λg.

k may be found by considering the system terminated with a matched load, when p = o

$$\therefore \quad k = V_L^2$$

Due to the spread of manufacturing tolerances of the detecting device, it will be necessary to normalise the voltage outputs obtained.

For the three probes under matched load conditions :-

$V1_L^2 = k1$ $\qquad V_{2L}^2 = k2$ $\qquad V_{3L}^2 = k3$

Let $k = \frac{k1 + k2 + k3}{3}$

The three normalisation factors are :-

$A1 = \frac{k}{k1}$ $\qquad A2 = \frac{k}{k2}$ $\qquad A3 = \frac{k}{k3}$

With a short-circuit termination,

$p = 1$ and $\theta = \pi$

so for probe 1,

$$V_{1sc}^2 = k1[2 + 2\ \mathrm{Cos}(\pi - 2\beta x_1)]$$

$$= 2V_{1L}^2\ (1 + \mathrm{Cos}\pi\ \mathrm{Cos}2\beta x_1 + \mathrm{Sin}\pi\ \mathrm{Sin}2\beta x_1)$$

$$= 2V_{1L}^2\ (1 - \mathrm{Cos}\ 2\beta x_1)$$

$$\therefore \mathrm{Cos}\ 2\beta x_1 = 1 - \frac{V_{1sc}^2}{2V_{1L}^2}$$

Similar calculations are made for the 2 other probes.

Let $U_1 = 1 - \frac{V_{1sc}^2}{2V_{1L}^2}$

$\therefore \quad Cos\ 2\beta x_1 = U_1$

$\therefore \quad 2\beta x = Cos^{-1}\ U_1$

There are an infinite number of angles whose cosines are $U_1$, producing an infinite number of values of $\lambda g$ :-

$$2\beta x = 2n\pi \pm Cos^{-1}U_1$$

where n is an integer.

Thus $\lambda g = \frac{2\pi x_1}{n\pi \pm 0.5\ Cos^{-1}U_1}$

Several values of $\lambda g$ can be ignored :-

a) Negative values i.e. for n = o

b) Those out of the range of interest

The correct value of $\lambda g$ can be found by comparison with those calculated at the other probes. The required value will appear at all three probe positions.

Measurements on an unknown termination

To find the impedance of the termination, p and $\theta$ must be found.

The outputs from the three probes may be expressed as :-

$$V_1^2 = k1[1 + p^2 + 2p\ Cos(\theta - 2\beta x_1)]$$

$$V_2^2 = k2[1 + p^2 + 2pCos(\theta - 2\beta x_2)]$$

$$V_3^2 = k3[1 + p^2 + 2pCos(\theta - 2\beta x_3)]$$

Normalisation and re-arrangement gives :-

$$V4 = A1V_1^2 = k[1 + p^2 + 2p\ (Cos\theta\ Cos2\beta x_1 - Sin\theta\ Sin2\beta x_1)] \quad ....4$$

$$V5 = A2V_2^2 = k[1 + p^2 + 2p\ (Cos\theta\ Cos2\beta x_2 - Sin\theta\ Sin2\beta x_2)] \quad ....5$$

$$V6 = A3V_3^2 = k[1 + p^2 + 2p\ (Cos\theta\ Cos2\beta x_3 - Sin\theta\ Sin2\beta x_3)] \quad ....6$$

Let $A = pSin\theta$

$B = pCos\theta$

So that $p = \sqrt{A^2 + B^2}$

Also let $C1 = Cos2\beta x_1$

$C2 = Cos2\beta x_2$

$C3 = Cos2\beta x_3$

$S1 = Sin2\beta x_1$

$S2 = Sin2\beta x_2$

$S3 = Sin2\beta x_3$

Substituting in 4, 5, 6 :-

$$V4 = k[1 + A^2 + B^2 + 2\ (BC_1 - AS_1)] \quad ............. 7$$

$$V5 = k[1 + A^2 + B^2 + 2\ (BC_2 - AS_2)] \quad ............. 8$$

$$V6 = k[1 + A^2 + B^2 + 2\ (BC_3 - AS_3)] \quad ............. 9$$

subtracting :-

$$V4 - V5 = 2kB(C1 - C_2) + 2kA(S2 - S1)$$

$$\therefore A = \frac{V4 - V5 - 2kB(C1 - C2)}{2k\ (S2 - S1)}$$

substituting for A in 7. produces a quadratic equation in $B^2$ which can be evaluated using the general expressions

$$ax^2 + bx + c = o$$

and $$x = \frac{-b \pm \sqrt{b^2 - 4ac}}{2a}$$

yielding 2 values of B.

Each value of B may then be substituted in equation 8. to produce 2 values of A

Similarly

$$V5 - V6 = 2kB(C_2 - C_3) + 2kA(S3 - S2)$$

$$A = \frac{V5 - V6 - 2kB(C2 - C3)}{2k(S3 - S2)}$$

substitution in 8. produces another quadratic in $B^2$ which gives 2 more values of B.

These values of B may be substituted in equation 9. to give 2 further values of A.

Comparisons of the two sets of values for A and B will yield the correct values, which can be used to extract $p\text{Sin}\theta$ and $p\text{Cos}\theta$.

A graph of the voltage reflection co-efficient can thus be obtained by plotting $p\text{Cos}\theta$ as the X co-ordinate, and $p\text{Sin}\theta$ as the Y co-ordinate.

An impedance plot is obtained by superimposing this graph onto a Smith chart.

Also note that $$\theta = \tan^{-1} \frac{A}{B}$$

and $$p = \frac{A}{\text{Sin}\theta} = \frac{B}{\text{Cos}\theta}$$

One example of apparatus according to the present invention will now be described with reference to Figures 1 and 2, of which:

FIGURE 1 is a diagram of the probe interface circuit together with the transmission line section and the probes, and

FIGURE 2 is a diagram of the digital signal processor circuit which receives as inputs the signals from the probe interface circuit and produces output signals representing the impedance or related parameter of the device under the test.

In Figure 1, the transmission line section is indicated at 1 and has connected to it a device 2 under test. Some examples of the device 2 may have a microwave output to which a further section 3 of transmission line is attached and which preferably incorporates a matched load. This further section and its associated components are shown in dotted form because they would not be provided in all embodiments of the apparatus. Amplifiers 4 are provided for the outputs from detectors 4A to which probes 4B provide signals representing the magnitude of the microwave energy in the part of the transmission line section where they are located. The probes 4B may be of the type Omni Spectra 204-8232A and the detectors 4A may be of the type Wiltron 75S50. The amplifiers 4 are of the type AD 517 manufactured by Analog Devices. It has been found that the detectors 4A are sensitive to changes in temperature and therefore a further

amplifier 5, like the amplifiers 4, are provided and which receives the output of a temperature transducer which may be of the type AD 590 manufactured by Analog Devices. The outputs of the amplifiers 4 are applied as inputs to respective sample and hold circuit 6 of type AD 582 manufactured by Analog Devices, and the outputs of the sample and hold circuit 6 and the amplifier 5 are applied to an analogue signal multiplexer 7 of type Analog Devices AD 7501. The output of the multiplexer 7 is applied to a 12-bit analogue to digital converter 8 of type Analog Devices AD 574 which feeds a parallel digital output via a bus 8A to a peripheral interface adaptor of type R 6522. The adaptor 9 provides a 3-bit address input to the multiplexer 7 via conductors 9A and also a control signal for the converter 8 via a conductor 9B. The converter generates a ready signal which it transmits to the adaptor 9 via a conductor 8B when it has completed an analogue to digital conversion.

The adaptor 9 is connected to the conductors of a bus 15 adapted to suit a microprocessor of the type 6502, which bus is also connected to provide input digital data to a digital to analogue converter 10 of type Analog Devices AD 7542. The monostable trigger 11 of type 74LS123 is set by the output of a comparator 12 of type National Semiconductor LM 319 when the voltage of a ramp output from a radio frequency generator 13, which ramp voltage represents the output frequency of the generator, reaches the value of the output voltage from the converter 10. The output from the monostable trigger 11 is applied to operate the hold circuits of the sample and hold circuits 6 and also provides via an interrupt connection a signal to the 6502 microprocessor to cause it to accept signals from the peripheral interface adaptor 9. The generator 13 is connected by a flange or other coupling 14 to the section 1 of transmission line.

It is expected that the user of the apparatus would provide an RF generator and therefore no particular type of generator is suggested.

The bus for the type 6502 microprocessor is also shown in Figure 2 where it is connected to the microprocessor 16 itself by means of a bus buffer transceiver 17 consisting of 74LS241 and 74LS245 integrated circuits. For test purposes an input from a block 17A can isolate the microprocessor 16 from the bus 15 so that the components attached to the bus can be tested by inputs fed in at 15A. Connected to the bus 15 are a random access memory of capacity 3k x 8 bits formed of integrated circuits of type HM 6116 manufactured by Hitachi, and three EPROM circuits 19 of type 2732, each of capacity 32k x 8 bits.The EPROM circuits 19 are selected by a bank select switch 20 formed of integrated circuits of type 74LS138. Output circuitry connected to the bus 15 include a video display controller 21 of type Thompson EF 9365 with a video refresh random access memory of capacity 16k x 16 bits formed of type 4116 integrated circuits and driving a video display monitor 23 of type Motorola MD 2000. In addition, two 12 bit digital to analogue converters 24 and 25 of type AD 7542 receive digital data from the bus 15 and feed deflection voltages Vy and Vx respectively to an X-Y plotter 26A which has a pen control signal fed to it by means of a latch 26 connected to the bus 15. Interfaces 27 and 38 are provided for connections 27A and 38A respectively for IEEE-488 and RS 232 external buses. The IL 488 interface 27 may be of type Motorola MC 68488 and the RS 232 inteface 38 may be an asynchronous communication adaptor of type R 6551. A keyboard 29 is connected to the bus 15 by means of an interface 28. For convenience of use the keyboard is coupled to the interface 28 by an infra-red link and uses a transmitter of type Plessey SL 490, the interface 28 including a Plessey SL 480 receiver and an ML 924 decoder.

A second microprocessor, of type Texas Instruments TMS 9995, is provided having its own bus 32 connectible to the bus 15 by a transceiver 30 formed of integrated circuits type 74LS241 and 74LS245. The transceiver 30 and microprocessor 33 are controlled by a controller 31 of type 6821 connected to the bus 15. The 9995 bus 32 is connected to high speed random access memory 34 of capacity 4k x 8 bits formed of integrated circuits of type 2148 and a bipolar read only memory 35 of capacity 1k x 8 bits formed by an integrated circuit type Texas Instruments TEP 28S86.

A second peripheral interface adaptor 36 is connected to the bus 15 to drive a printer buffer 37 connected to a parallel printer interface 37A. No particular construction is suggested for the interface 37A since this will vary in dependence upon the type of printer used.

Detailed circuits of parts of the probe interface circuit shown in Figure 1 and the digital signal processor circuit shown in Figure 2 are set out in Figures 3 to 8 in which the same reference numerals as are used in Figures 1 and 2 are employed, so that the part shown can readily be recognised.

Figure 3 shows the sample and hold circuit 6 together with the multiplexer 7 and analogue to digital converter 8 of Figure 1.

Figure 4 shows the peripheral interface adaptor 9 of Figure 1 together with its input connections from the converter 8 and its output connections to the bus 15 shown in Figure 4 but not shown in Figure 1 are buffers constructed from individual integrated circuits of type 74LS241 and gating circuits for selecting the registers in the adaptor 9 formed of an integrated circuit of type 74LS125A.

Figure 5 shows the random access memory 18 of Figure 2 together with chip select circuitry not shown in Figure 2 and formed by an integrated circuit of type 74LS183.

Figure 6 shows one of the EPROM circuits 19 of Figure 2 together with chip select circuitry included in the switch 20.

Figure 7 shows the keyboard interface 28 which includes the receiver and decoder for infra-red signals from the transmitter connected directly to the keyboard 29. This interface includes a versatile interface adaptor of type 6522 for connecting the keyboard to the bus 15.

Figure 8 shows the RS 232 interface circuit 38 including an integrated circuit of type R 6551 asynchronous communication interface adaptor together with a 1.8432 MHz oscillator.

In the operation of the apparatus described above, before the device 2 the impedance of which is to be found is connected to the output of the transmission line section 1, the calibration measurements are carried out using a matched load and a short circuit load in place of the device 2. As described above in the mathematical explanation of the operation of the apparatus these calibration measurements provide an indication of the sensitivities of the detectors so that their outputs can be normalised, and a measure of $\lambda_g$, the wavelength of microwave energy in the transmission line section 1. The measurements are performed at a number of frequencies throughout the range and the values stored. Although the response of the detectors is almost independent of frequency, the response of a probe and a detector together can vary considerably with frequency. The value of $\lambda_g$ is also taken for different frequencies so that the inaccuracies in the frequency of the output of the R.F. generator can be corrected; in fact the frequency can be calculated from $\lambda_g$

using the known characteristics of the transmission line from which the section 1 is made, and the exact relationship between the ramp voltage output and the frequency determined. If desired the corrected frequency may be displayed as an output. The results of the calibration measurements may be stored in the EPROM's 19, and if desired each EPROM may be arranged to store, amongst other data, the response of a respective detector and probe, but in the following description of the operation the results of the calibration measurements are stored in the RAM 18.

The following is a list of operations which are performed by the apparatus described in the sequence given:-

1. Power on, perform self check.
2. Display equipment connection details to the operator.
3. Instruct operator to attach matched load to the probe unit.
4. Instruct operator to increase RF output level on RF generator gradually.
5. Monitor RF level in the probe unit using the outputs from the probes.
6. When the RF level is optimum i.e. between ¼ and ½ of the maximum which the probes can handle display "Level Correct".
7. Display "Enter Probe Unit Codes". These are reference numbers allocated to the different probes so that correction can be made for their parameters.
8. Retrieve probe unit parameters from store (X 1, 2 & 3, calibration constants).
9. Display "Set start frequency on generator to xxxxGHz".
10. Display "Set stop frequency on generator to xxxxGHz".
11. Display "Set sweep time to xxx secs. & press enter button on keyboard".
12. Dump program for matched load test from 6502 EPROM to 9995 RAM.
13. For each of 4096 discrete frequencies between F START (CAL) & F STOP (CAL):-
    a) Input probe voltages and temperature from probe assembly.

b) Retrieve compensation factors and calibration constants for selected probe unit from 6502 EPROM.

c) Dump data (a) & (b) to 9995 RAM and initiate 9995 matched load mathematics program to calculate K and probe sensitivity normalisation constants (A1, A2 & A3).

d) Transfer results of (c) to 6502 RAM.

14. Display "Attach short circuit" and press "RETURN" key.

15. Dump program for short circuit test from 6502 EPROM to 9995 RAM.

16. For each of 4096 discrete frequencies between F START (CAL) AND F STOP (CAL):-

a) Input probe voltages and temperature from probe assembly.

b) Retrieve K, A1, A2 and A3 compensation factors and calibration constants from 6502 ROM & RAM.

c) Dump data (a) & (b) to 9995 RAM and initiate 9995 9995 Short Circuit load maths program to calculate $\lambda g$.

d) Transfer results of (c) to 6502 RAM.

17. Display "Attach unknown load & press RETURN key".

18. Display "Enter Start Frequency (GHz) and press "ENTER" Key", Input F START (MEAS). Display "Enter Stop Frequency (GHz) and press "ENTER" Key", Input F STOP (MEAS). Display measurement cycle menu.

e.g. Display Format 1. Smith Chart
2. Amplitude vs. Frequency
3. Phase vs. Frequency.

Cursor control instructions.

19. Dump program for measurement test from 6502 EPROM to 9995 RAM.
20. For each discrete frequency between F START (MEAS) & F STOP (MEAS):-
    a) Input probe voltages & temperature from probe unit.
    b) Retreive calibration constants, compensation factors, K, A1, A2, A3 & $\lambda g$ from 6502 EPROM & RAM.
    c) Dump date a) & b) to 9995 RAM.
    d) Initiate 9995 measurement maths program to derive Amplitute and phase values.
    e) Transfer results of d) to 6502 RAM.
21. While 9995 is calculating results for each frequency, format previous result according to display type selected and send this information to video display processor.
22. Display graph in selected format with indication of current cursor position.
23. Display F START (MEAS) & F STOP (MEAS).
24. Display Frequency, Amplitude and phase at current cursor position.
25. Display Interrupt options menu.
26. Repeat 22 to 27 until Interrupt occurs.

Some further details of certain of the operations are given below:-

1. On switch on, the power on reset circuitry 39 resets the two microprocessors 16 & 33 and sets all other periphorals to a known condition. The controller 31 asserts hold on the 9995 33 which sets all its bus lines 32 to a high impedance state.

The 6502 16 then executes a "self check" subroutine, which exercises the RAM 18 and checks internal supply voltages via the analogue multiplexer 7, the 12-bit Analogue to Digital Convertor 8 and the peripheral interface adaptor 9.

2. A series of vector coordinates stored in EPROM 19 is transferred over the bus 15 to the video display controller 21. This then calculates line plots and stores them in the video refresh RAM 21. This results in a high resolution drawing of connection details to be displayed on the video display monitor.

5. The probes, which are embedded in the probe unit 1, convert RF energy into a d.c. level. These voltages are conditioned and amplified by the amplifiers 4 and continuous samples taken by the sample and hold amplifiers 6. A binary representation of any probe voltage can be input to the 6502 16 via the multiplexer 7, the analogue to digital converter 8, PIA 9 and 6502 Bus 15. These levels are compared to optimum levels held in store (EPROM 19).

Account is taken of the fact that a probe voltage with a short circuit load can be four times as great as its output with a matched load.

11. The action of pressing the "ENTER" button on the keyboard causes an interrupt to the 6502 which indicates that the operator has completed adjustments requested in steps 7, 9, 10 and 11.

12. The sequence for transferring program and parameter data from the 6502 memory to the 9995 High Speed RAM 34 is as follows.

a) The 'hold' line on the 9995 is made active, which isolates the 9995 MPU 33 from its bus 32.

b) The controller 31 switches the bus buffer/transceiver 30 on, which connects the 6502 bus 15 to the 9995 bus 32.

c) This means the high speed RAM34 now becomes part of the 6502 memory map, thus enabling a transfer of data under 6502 control from either EPROM 19 or RAM 18 to the high speed RAM 34.

d) After the transfer, the bus buffers 30 isolate the two busses.

13a. To acquire a set of probe voltages at a particular frequency, a voltage is applied to one input of comparator 12 from the 6502, via the digital to analogue converter 10.

The other comparator input is the ramp voltage output from the RF generator, which is proportional to frequency.

When the ramp voltage in one comparator input exceeds the set voltage on the other input, the comparator output changes state.

The monostable multivibrator 11 outputs a short pulse on a positive transition from the comparator.

This pulse enables the sample and hold amplifiers 6 to acquire the probe voltages and also interrupts the 6502 to indicate that the acquisition is complete.

The 6502 now selects each probe voltage (via PIA 9 and MPX 7), and commands the A/D converter 8 to initiate a conversion.

13c.)
16c.)
20d.) The high speed RAM 34 contains the 9995 program and the arguments for the mathematics to be performed.

The Bipolar PROM 35 contains mathematical subroutines which can be called from the main program.

The 9995 'hold' line is released which causes the program to be executed. Results of calculations are returned to the high speed RAM 34.

The last instruction in the program is "IDLE" which causes an output to toggle. This interrupts the 6502 to indicate that the calculations are complete. Other interrupts are:

KEYBOARD INTERRUPT functions are as follows:-

1. Dump numeric data to printer (Parallel & RS 232).
2. Change display format (Display menu).
3. Set Frequency for digital readout of results.
4. Change Start/Stop frequencies.
5. Expand display.
6. Transfer complete control to I.E.E.E. controller.
7. Output graphics to X-Y plotter (Vx, Vy, Pen up/down).
8. Cursor up in frequency or Cursor down in frequency.
9. Return to calibrate mode.

ERROR INTERRUPT

Display cause of error and instruct on procedure to rectify if possible.

The microprocessor 33 performs the calculations set out earlier to calculate the impedance or other parameter of the device under test, and the details of the way in which the calculations are preformed and what results are stored are set out in Table 1. It will be noted that the programs for the microprocessor 33 are stored in the EPROM's 19 and are transferred to the RAM 34 for execution; this is because the access time of the RAM 34 is much shorter than that of the EPROM 19 and it is important that the calculations be performed quickly. It is intended that the operation of the apparatus is sufficiently rapid for a useful display of the impedance to be produced in real time on the monitor 23 or at a similar speed on the X-Y plotter 26A. The use of the calibration measurements also speeds up the operation of the apparatus because the calculations are simpler and shorter than they would otherwise be. The apparatus may also be arranged to produce a more detailed output, for example up to 4096 frequency points, on the monitor 23 or the plotter 26A, but obviously the period of time needed to produce such an output would be longer than for a simpler output of, say, 32 frequency points.

A typical embodiment of the invention might have the following features which could be obtained by suitable programming of the microprocessor 16 and the use of the video display controller 21.

It can accept an input voltage from a fourth probe and use this in conjunction with the three other inputs to calculate and display insertion loss.

During the calibration procedure it would be possible to set up the start and stop frequencies and display them on the screen.

During calibration it would be possible to check for variations in incident power and the correlation between ramp voltage and frequency.

During calibration a check could be made for deterioration in crystal sensitivity and noise output and a failure report produced if necessary.

The R.F. generator can be swept manually to any frequency within band. This frequency may be indicated by brightening up trace or providing marker.

It can either sweep plots of p and θ against frequency (Smith Chart) /p/ against frequency, or Insertion loss against frequency. OR display p, θ, and I.L. in alphanumeric form at spot frequencies.

It may have a fault finding system to determine faults to board level.

It may have operator instructions on calibration and measurement procedures in ROM which can be displayed to prompt the operator.

Instructions may be provided to enable a selected part of the displayed image to be displayed on a larger scale and possibly with higher accuracy. Additional display storage may be provided to enable a previous image to be displayed with the current one so that, for example, the effects of tuning can be seen.

From a consideration of the calculations performed by the apparatus it will be apparent that the positions of the probes influence the accuracy obtainable in the result, and indeed if the spacing of the probes is a multiple of half a wavelength of the microwave energy in the transmission line section then it will not be possible to solve the equations. The constraints on the probe positions may be summarised as follows:-

1. No pair of probes may be spaced by a distance of a multiple of half a wavelength of the energy in the transmission line section for any frequency in the range of interest.

2. For any frequency in the range of interest at least one of the probes must be spaced from the load by a distance not close to an integral multiple of a quarter wavelength of the energy in the transmission line section.

3. The ratios of the probe distances from the load, $x_1/x_2$ and $x_1/x_3$, must be of the form p/q where p and q are prime numbers greater than the number of wavelengths in the transmission line section of the microwave energy in the distances.

All of these constraints arise because of the periodic nature of the sine function. It can be shown that it is desirable to keep the probe distances as small as is practicable.

Although the invention has been described with reference to a specific embodiment it is not limited to this embodiment and many alterations may be made, possibly arising from improvements in microcomputer components, without departing from the invention.

TABLE I

| CALIBRATION PROCEDURE | STORED |
|---|---|
| First attach matched load. $\rho = 0$, $\theta$ = any value | |
| We then get at first probe | |
| $V_{1L}^2 = k_1 + k_1(0) + 2k(0)$ | $k_1$ |
| $V_{1L}^2 = k_1$ | |
| Similarly | |
| $V_{2L}^2 = k_2$ | $k_2$ |
| $V_{3L}^2 = k_3$ | $k_3$ |
| Let $k = \frac{k_1 + k_2 + k_3}{3} = \frac{V_{1L}^2 + V_{2L}^2 + V_{3L}^2}{3}$ | $k$ |
| 2. Allow for different crystal sensitivities<br>Normalise as follows: | |
| Multiply $V_{1L}^2$ by $\frac{k}{k_1} = V_{1N}^2$ | $\frac{k}{k_1} = A_1$ |
| Multiply $V_{2L}^2$ by $\frac{k}{k_2} = V_{2N}^2$ | $\frac{k}{k_2} = A_2$ |
| Multiply $V_{3L}^2$ by $\frac{k}{k_3} = V_{3N}^2$ | $\frac{k}{k_3} = A_3$ |
| $\therefore\ V_{1N}^2 = V_{2N}^2 = V_{3N}^2 = k$ | |
| Then attach short circuit $\rho = 1$, $\theta = \pi$ | $2x_1 = x_1$ |
| We then get at first probe | $2x_2 = x_2$ |
| $V_{1s}^2 = k_1 + k_1(1)^2 + 2k_1.1.\cos(\pi-2\beta x_1)$ | $2\ x_3 = x_3$ |
| $V_{1s}^2 = 2k_1\left[1 + \cos(\pi-2\beta x_1)\right]$ | |
| $V_{1s}^2 = 2k_1\left[1 + \cos\pi.\cos2\beta x_1 + \sin\pi.\sin2\beta x_1\right]$ | |
| $V_{1s}^2 = 2k_1\left[1 - \cos2\beta x_1\right]$ | |

Normalise by multiplying by $\frac{k}{k_1} = A_1$

$$J_1 \cdot A_1 = 2k\left[1-\cos 2\beta x_1\right]$$

$$Y_1 = 2k\left[1-\cos 2\beta x_1\right]$$

$$Y_1 = 2k - 2k\cos 2\beta x_1$$

$$2k.\cos 2\beta x_1 = 2k - Y_1$$

$$\cos 2\beta x_1 = 1 - \frac{Y_1}{2k} = U_1$$

$$2\beta x_1 = \cos^{-1} U_1 = \theta$$

The angles whose cosines are $U_1$ are given by

$$2n\pi + \theta_1$$

and $2n\pi - \theta_1$

$$2\beta x_1 = 2n\pi + \cos^{-1} U_1$$

or

$$2\beta x_1 = 2n\pi - \cos^{-1} U_1$$

$$\beta x_1 = n\pi \pm \frac{\cos^{-1} U_1}{2}$$

Now $\beta = \frac{2\pi}{\lambda_g}$

$$\therefore \lambda_g = \frac{2\pi x_1}{n\pi \pm \frac{\cos^{-1} U_1}{2}} = \frac{\pi X_1}{n\pi \pm \frac{\cos^{-1} U_1}{2}}$$

$$= \frac{2\pi x_1}{n\pi \pm \frac{Z_1}{2}} = \frac{\pi X_1}{n\pi \pm \frac{Z_1}{2}}$$

This can be evaluated for different values of n starting at n = 0

similarly

$$\lambda_g = \frac{2\pi x_2}{n\pi \pm \frac{Z_2}{2}} = \frac{\pi X_2}{n\pi \pm \frac{Z_2}{2}}$$

$$\lambda_g = \frac{2\pi x_3}{n\pi \pm \frac{Z_3}{3}} = \frac{\pi X_3}{n\pi \pm \frac{Z_3}{2}}$$

$$V_{1s}^{2} = J_1$$

$$V_{2s}^{2} = J_2$$

$$V_{3s}^{2} = J_3$$

$$V_{1s}^{2} \cdot \frac{k}{k_1} = J_1A_1 = Y_1$$

$$V_{2s}^{2} \cdot \frac{k}{k_2} = J_2A_2 = Y_2$$

$$V_{3s}^{2} \cdot \frac{k}{k_3} = J3A3 = Y_3$$

$$1 - \frac{Y_1}{2k} = U_1$$

$$1 - \frac{Y_2}{2k} = U_2$$

$$1 - \frac{Y_3}{2k} = U_3$$

$$\cos^{-1} U_1 = Z_1$$

$$\cos^{-1} U_2 = Z_2$$

$$\cos^{-1} U_3 = Z_3$$

There are obviously an infinite number of values of $\lambda_g$ obtainable at each probe position depending on the value of n.

Negative values of $\lambda_g$ can be neglected.

Negative values of $\lambda_g$ only occurs when n = 0, since $Z_3 \leqslant \frac{\pi}{2}$

If we define limits of $\lambda_g$ for each probe

i.e. Longest wavelength = $\lambda_{gL}$ = $W_1$ $W_1$

Shortest wavelength = $\lambda_{gs}$ = $W_2$ $W_2$

Then values of $\lambda_g$ outside these limits can be neglected.

As 'n' increases $\lambda_g$ decreases, so that the computation of $\lambda_g$ can stop when the lower of the two values (given by +Z) is less than $W_2$.

The remaining values of $\lambda_g$ at each probe position must then be compared. The correct value is that which appears at each position.

Let the correct value of $\lambda_g$ = W W

Then

$$\beta = \frac{2\pi}{\lambda_g} = \frac{2\pi}{W}$$

$$2\beta x_1 = \beta X_1 = \frac{2\pi X_1}{W} = B_1$$ $B_1$

$$2\beta x_2 = \beta X_2 = \frac{2\pi X_2}{W} = B_2$$ $B_2$

$$2\beta x_3 = \beta X_3 = \frac{2\pi X_3}{W} = B_3$$ $B_3$

---

Let

$\sin B_1 = S_1$ $S_1$

$\sin B_2 = S_2$ $S_2$

$\sin B_3 = S_3$ $S_3$

Let

$\cos B_1 = C_1$ $C_1$

$\cos B_2 = C_2$ $C_2$

$\cos B_3 = C_3$ $C_3$

Let

$S_1 - S_2 = D_1$ $D_1$

$C_1 - C_2 = D_2$ $D_2$

$S_2 - S_3 = D_3$ $D_3$

$C_2 - C_3 = D_4$ $D_4$

Let

$$2kD_1 = E_1$$
$$2kD_2 = E_2$$
$$2kD_3 = E_3$$
$$2kD_4 = E_4$$

Let

$$\frac{E_1}{E_2} = G_2$$

$$\frac{E_3}{E_4} = G_4$$

Let

$$2kG_2 = P_1$$
$$2kS_1 - P_1C_1 = P_2$$
$$2kG_4 = P_3$$
$$2kS_2 - P_3G_2 = P_4$$

Let

$$2kC_1 = Q_1$$
$$2kC_2 = Q_2$$

Let

$$k + G_2{}^2k = H_1$$
$$k + G_4{}^2k = H_2$$

Let

$$\frac{1}{2H_1} = R_1$$

$$\frac{1}{2H_2} = R_2$$

Let

$$E_5 = \frac{1}{E_2}$$

$E_1$
$E_2$
$E_3$
$E_4$

$G_2$

$G_4$

$P_1$
$P_2$
$P_3$
$P_4$

$Q_1$
$Q_2$

$H_1$
$H_2$

$R_1$

$R_2$

$E_5$

## MEASUREMENT PROCEDURE

**CALCULATION performed and stored**

The following formulae apply

$$V_1^2 = k_1 + k_1\rho^2 + 2k_1\rho\cos(\theta-2\beta x_1) \quad \ldots\ldots (1)$$

$$V_2^2 = k_2 + k_2\rho^2 + 2k_2\rho\cos(\theta-2\beta x_2) \quad \ldots\ldots (2)$$

$$V_3^2 = k_3 + k_3\rho^2 + 2k_3\rho\cos(\theta-2\beta x_3) \quad \ldots\ldots (3)$$

USING (1) & (2)

$$= L_1 = k_1 + k_1\rho^2 + 2k_1\rho\cos(\theta - B_1)$$

$$= L_2 = k_2 + k_2\rho^2 + 2k_2\rho\cos(\theta - B_2)$$

NORMALISE

$$V_1^2A_1 = A_1L_1 = k + k\rho^2 + 2k\rho\cos(\theta - B_1)$$

$$V_2^2A_2 = A_2L_2 = k + k\rho^2 + 2k\rho\cos(\theta - B_2)$$

$$V_4 = k + k\rho^2 + 2k\rho(\cos\theta\cos B_1 + \sin\theta\sin B_1)$$

$$V_5 = k + k\rho^2 + 2k\rho(\cos\theta\cos B_2 + \sin\theta\sin B_2)$$

Let $\rho\sin\theta = M$

$\rho\cos\theta = N$

Then $\rho = \sqrt{M^2 + N^2}$

$$V_4 = k + k(M^2 + N^2) + 2k(NC_1 + MS_1)$$

$$V_5 = k + k(M^2 + N^2) + 2k(NC_2 + MS_2)$$

Let

$$V_4 - V_5 = F_1$$

$$V_5 - V_6 = F_2$$

USING (2) & (3)

$$V_2^2 = L_2 = k_2 + k_2\rho^2 + 2k_2\rho\cos(\theta - B_2)$$

$$V_3^2 = L_3 = k_3 + k_3\rho^2 + 2k_3\rho\cos(\theta - B_3)$$

$$V_2^2A_2 = A_2L_2 = k + k\rho^2 + 2k\rho\cos(\theta - B_2)$$

$$V_3^2A_3 = A_3L_3 = k + k\rho^2 + 2k\rho\cos(\theta - B_3)$$

$$V_5 = k + k\rho^2 + 2k\rho(\cos\theta\cos B_2 + \sin\theta\sin B_2)$$

$$V_6 = k + k\rho^2 + 2k\rho(\cos\theta\cos B_3 + \sin\theta\sin B_3)$$

$$V_5 = k + k(M^2 + N^2) + 2k(NC_2 + MS_2)$$

$$V_6 = k + K(M^2 + N^2) + 2k(NC_3 + MS_3)$$

CALCULATION performed and stored:

$V_1^2 = L_1$

$V_2^2 = L_2$

$V_3^2 = L_3$

$A_1L_1 = V_4$

$A_2L_2 = V_5$

$A_3L_3 = V_6$

*

*

$V_4 - V_5 = F_1$

$V_5 - V_6 = F_2$

$$F_1 = 2k(NC_1 + MS_1 - NC_2 - MS_2)$$
$$F_1 = 2kN(C_1 - C_2) + 2kM(S_1 - S_2)$$
$$F_1 = 2kND_2 + 2kMD_1$$
$$F_1 = E_2N + E_1M$$

Let
$$\frac{F_1}{E_2} = G_1 \; ; \quad \frac{F_2}{E_4} = G_3$$

$$N = \frac{F_1}{E_2} - \frac{E_1}{E_2}.M$$

$$N = G_1 - G_2.M$$

Going back to *

$$V_4 = k + k(M^2+N^2) + 2k(NC_1+MS_1)$$
$$V_4 = k + kM^2 + kN^2 + 2kNC_1 + 2kMS_1$$
$$V_4 = k + kM^2 + k(G_1-G_2M)^2 + 2kC_1(G_1-G_2M) + 2kMS_1$$
$$V_4 = k + kM^2 + kG_1{}^2 - 2kG_1G_2M + kG_2{}^2M^2 + 2kC_1G_1 - 2kC_1G_2M + 2kMS_1$$

$$M^2(k+kG_2{}^2) + M(2kS_1-2kG_1G_2-2kC_1G_2) + k + kG_1{}^2 - A_1L_1 + 2kC_1G_1 = 0$$

$$M^2H_1 + M(P_2-P_1G_1) + Q_1G_1 + k + kG_1{}^2 - A_1L_1 = 0$$

Let
$$P_2 - P_1G_1 = H_3$$
$$P_4 - P_3G_3 = H_4$$
$$Q_1G_1 + k + kG_1{}^2 - L_1 = H_5$$
$$Q_2G_3 + k + kG_3{}^2 - L_2 = H_6$$

$$F_2 = 2k(NC_2 + MS_2 - NC_3 - MS_3)$$
$$F_2 = 2kN(C_2 - C_3) + 2kM(S_2 - S_3)$$
$$F_2 = 2kND_4 + 2kMD_3$$
$$F_2 = E_4N + E_3M$$

$$N = \frac{F_2}{E_4} - \frac{E_3}{E_4}.M$$

$$N = G_3 - G_4.M$$

$$V_5 = k + k(M^2+N^2) + 2k(NC_2+MS_2)$$
$$V_5 = k + kM^2 + kN^2 + 2kNC_2 + 2kMS_2$$
$$V_5 = k + kM^2 + k(G_3-G_4M)^2 + 2kC_2(G_3-G_4M) + 2kMS_2$$
$$V_5 = k + kM^2 + kG_3{}^2 - 2kG_3G_4M + kG_4{}^2M^2 + 2kC_2G_3 - 2kC_2G_4M + 2kMS_2$$

$$M^2(k+kG_4{}^2) + M(2kS_2-2kG_3G_4-2kC_2G_4) + k + kG_3{}^2 + 2kC_2G_3 - A_2L_2 = 0$$

$$M^2H_2 + M(P_4-P_3G_3) + Q_2G_3 + k + kG_3{}^2 - A_2L_2 = 0$$

CALCULATION performed and stored

$$\frac{F_1}{E_2} = G_1 ; \frac{F_2}{E_4} = G_3$$

$$P_2-P_1G_1 = H_3$$
$$P_4-P_3G_3 = H_4$$
$$Q_1G_1+k+kG_1{}^2-L_1 = H_5$$
$$Q_2G_3+k+kG_3{}^2-L = H_6$$

**CALCULATION performed and stored**

$$H_1M^2 + H_3M + H_5 = 0$$

$$M = \frac{-H_3 \pm \sqrt{H_3^2 - 4H_1H_5}}{2H_1}$$

Let

$$\sqrt{H_3^2 - 4H_1H_5} = H_7$$

$$\sqrt{H_4^2 - 4H_2H_6} = H_8$$

$$M_1 = (-H_3 + H_7)\ R_1$$

$$M_2 = (-H_3 - H_7)\ R_1$$

$$= -H_3R_1 - H_7R_1$$

$$= M_1 - H_7R_1 - H_7R_1$$

$$M_2 = M_1 - 2H_7R_1$$

At this stage we have 4 values of 'M' and 4 corresponding values of 'N'

i.e.

$$N_1 = G_1 - G_2M_1$$

$$N_2 = G_1 - G_2M_2$$

Compare

$M_1$ with $M_3$

$M_1$ with $M_4$

$M_2$ with $M_3$

$M_2$ with $M_4$

EITHER

$M_1$ will equal $M_3$ or $M_4$

OR

$M_2$ will equal $M_3$ or $M_4$

IF $M_1 = M_3$ or $M_4$ THEN $M_1$, $N_1$ are used

IF $M_2 = M_3$ or $M_4$ THEN $M_2$, $N_2$ are used

$$H_2M^2 + H_4M + H_6 = 0$$

$$M = \frac{-H_4 \pm \sqrt{H_4^2 - 4H_2H_6}}{2H_2}$$

$$M_3 = (-H_4 + H_8)\ R_2$$

$$M_4 = (-H_4 - H_8)\ R_2$$

$$= -H_4R_2 - H_8R_2$$

$$= M_3 - H_8R_2 - H_8R_2$$

$$M_4 = M_3 - 2H_8R_2$$

$$N_3 = G_3 - G_4M_3$$

$$N_4 = G_3 - G_4M_4$$

$\sqrt{H_3^2 - 4H_1H_5} = H_7$

$\sqrt{H_4^2 - 4H_2H_6} = H_8$

$(-H_3+H_7)R_1 = M_1$

$M_1 - 2H_7R_1 = M_2$

$(-H_4+H_8)R_2 = M_3$

$M_3 - 2H_8R_2 = M_4$

Calc. $N_1$ or $N_2$ from

$N_1 = G_1 - G_2M_1$

$N_2 = G_1 - G_2M_2$

| | |
|---|---|
| Calculate $\rho$ | |
| $\rho = ABS\sqrt{M^2 + N^2} = R$ | $R = ABS\sqrt{M^2 + N^2}$ |
| IF PRINT OUT OF '$\theta$' IS NOT REQUIRED IT IS NOT NECESSARY AT THIS STAGE TO CALCULATE $\theta$ | |
| SINCE | |
| $\rho \sin\theta = M$ = Y co-ordinate = Y co-ordinate | |
| $\rho \cos\theta = N$ = X co-ordinate = X co-ordinate | PLOT X, Y |
| IF THE VALUE OF '$\theta$' IS REQUIRED THEN PROCEED AS FOLLOWS | |
| Let | |
| $\theta_1 = \tan^{-1}\frac{M_5}{N_5} = T_1$ | $\tan^{-1}\frac{M_5}{N_5} = T_1$ |
| $\theta_2 = \tan^{-1}\frac{M_5}{N_5} + \pi = T_2$ | $\tan^{-1}\frac{M_5}{N_5} + \pi = T_2$ |
| Let | |
| $N_6 = R\cos\theta_1$ | $R\cos\theta_1 = N_6$ |
| $N_7 = R\cos\theta_2$ | $R\cos\theta_2 = N_7$ |
| Compare $N_6$ with $N_5$ | |
| $N_7$ with $N_5$ | |
| IF $N_6 = N_5$ THEN $T_1$ is correct value | |
| IF $N_7 = N_5$ THEN $T_2$ is correct value | |
| $N_5 = G_1G_2M_5$ OR | |
| $N_5 = G_3G_4M_5$ | |
| $M_5$ = result of comparison of $M_1 \rightarrow M_4$ | |

4C

CALCULATED AND STORED AT CALIBRATION

$k = \frac{1}{3}(k_1 + k_2 + k_3)$
$B_1 = 2\beta x_1$
$B_2 = 2\beta x_2$
$B_3 = 2\beta x_3$
$S_1 = \sin B_1$
$S_2 = \sin B_2$
$S_3 = \sin B_3$
$C_1 = \cos B_1$
$C_2 = \cos B_2$
$C_3 = \cos B_3$
$D_1 = S_1 - S_2$
$D_2 = C_1 - C_2$
$D_3 = S_2 - S_3$
$D_4 = C_2 - C_3$
$E_1 = 2kD_1$
$E_2 = 2kD_2$
$E_3 = 2kD_3$
$E_4 = 2kD_4$
$G_2 = E_1/E_2$
$G_4 = E_3/E_4$
$H_1 = k + G_2^2 k$
$H_2 = k + G_4^2 k$
$P_1 = 2kG_2$
$P_2 = 2kS_1 - P_1G_1$
$P_3 = 2kG_4$
$P_4 = 2kS_2 - P_3G_3$
$Q_1 = 2kC_1$
$Q_2 = 2kC_2$
$R_1 = 1/2H_1$
$R_2 = 1/2H_2$
$E_5 = 1/E_2$
$E_6 = 1/E_4$
$S_1 = 2kC_1$
$S_2 = 2kC_2$

MEASUREMENT CYCLE

1. $G_1 = F_1E_5$
2. $G_3 = F_2E_6$
3. $H_3 = P_2 - P_1G_1$
4. $H_4 = P_4 - P_3G_3$
5. $H_5 = k + kG_1^2 - V_1^2 + S_1G_1$
6. $H_6 = k + kG_3^2 - V_2^2 + S_2G_3$
7. $M_1 = (-H_3 + \sqrt{H_3^2 - 4H_1H_5})\ R_1$
8. $M_2 = H_5 / H_1M_1$
9. $M_3 = (-H_4 + \sqrt{H_4^2 - 4H_2H_6})\ R_2$
10. $M_4 = H_6 / H_2M_3$
11. $M_5$ = (Result of compare of $M_1$ -- $M_4$)
12. $N_5 = G_{1/3} - G_{2/4}\ M_5$
13. $\rho$ determined

CLAIMS:

1. Apparatus for measuring the impedance of a microwave device or a parameter related thereto by reference to the standing wave pattern set up in a transmission line along which microwave energy is applied to the device, the apparatus including

an input for oscillations from a microwave oscillator,

a section of transmission line for applying the oscillations to a device the impedance or other parameter of which is to be measured,

a plurality of probes for sampling the microwave energy at respective spaced positions along the section of line and producing output voltages,

a probe interface circuit connected to receive the output voltages from the probes and produce corresponding digital values therefrom,

a digital signal processor circuit connected to receive the digital values as inputs from the probe interface circuit, the circuit being programmed to obtain calibration data representing the sensitivities of the probes and the wavelength of the microwave energy in the transmission line section and to calculate in response to the inputs, the spacing of the probes and the calibration data the effective impedance of the device connected to the transmission line section, or data related to that impedance, as indicated by the phase and amplitude of a standing wave pattern set up in the section, the energy of which is sampled by the probes, and to generate output signals, and

output means responsive to the output signals to produce a display representing the impedance or related parameter.

2. Apparatus according to claim 1 in which the digital signal processor circuit is programmed to store data derived from digital values received from the probe interface circuit when a first load matched to the impedance of the transmission line section and a second load short circuiting the transmission line section are individually attached to the section, the derived data forming the calibration data and representing the normalised sensitivity of the probes and the wavelength of the microwave energy in the transmission line section.

3. Apparatus according to claim 1 or 2 including temperature responsive means coupled to the transmission line section whereby digital values representing the temperatures of the probes can be passed to the digital signal processor circuit to enable the effects of temperature changes on the probes to be compensated.

4. Apparatus according to claim 2 with or without the feature of claim 3, wherein the digital signal processor includes a first microprocessor and a second microprocessor, the first microprocessor receiving the digital values from the probe interface circuit, instructing the second microprocessor to perform calculations on the digital values and receiving output values from the second microprocessor to produce therefrom the output signals, and the second microprocessor performing the calculations while the first microprocessor is performing other functions.

5. Apparatus according to claim 4, wherein the second microprocessor is provided with high speed random access memory which it uses when performing the calculations, and the first microprocessor has access to the high-speed random access memory to enter therein and extract therefrom digital values.

6. Apparatus according to claim 5, wherein the first microprocessor also transfers calculations program data for the second microprocessor from a read-only memory to the high-speed random access memory.

7. Apparatus according to claim 6 wherein the calculation program data includes data relating to the parameters of the probes.

8. Apparatus according to any preceding claim wherein the spacing of the probes along the transmission line section is chosen so that relative to the wavelength of the energy in the section no two probes are separated by an integral number of half wavelengths, at least one probe is separated from the device by a distance not close to an integral number of quarter wavelengths, and the ratios of the spacing distances of the probes from the device are equal to the ratios of prime numbers each greater than the number of wavelengths in the spacing distances.

9. Apparatus according to any preceding claim wherein the device has an outlet for microwave energy, the apparatus including a further transmission line section connected to the outlet of the device, the further section having a fourth probe and a matched load so that the foruth probe measures the amount of microwave energy transmitted by the device, and means for producing a digital value from the output of the fourth probe,which digital value is applied to the digtal signal processor circuit which is programmed to produce output signals representing the transmission performance of the device.

10. Apparatus according to any preceding claim wherein the probe interface circuit has an input for a variable d.c. signal from a microwave oscillator representing the frequency of the oscillations produced, means for comparing the level of the d.c. signal with a preset value generated in response to an output of the digital signal processor circuit, and means for holding the digital values representing probe outputs in response to an output from the comparing means so that the values held represent probe outputs at a frequency corresponding to the preset value.

0064413

1/8

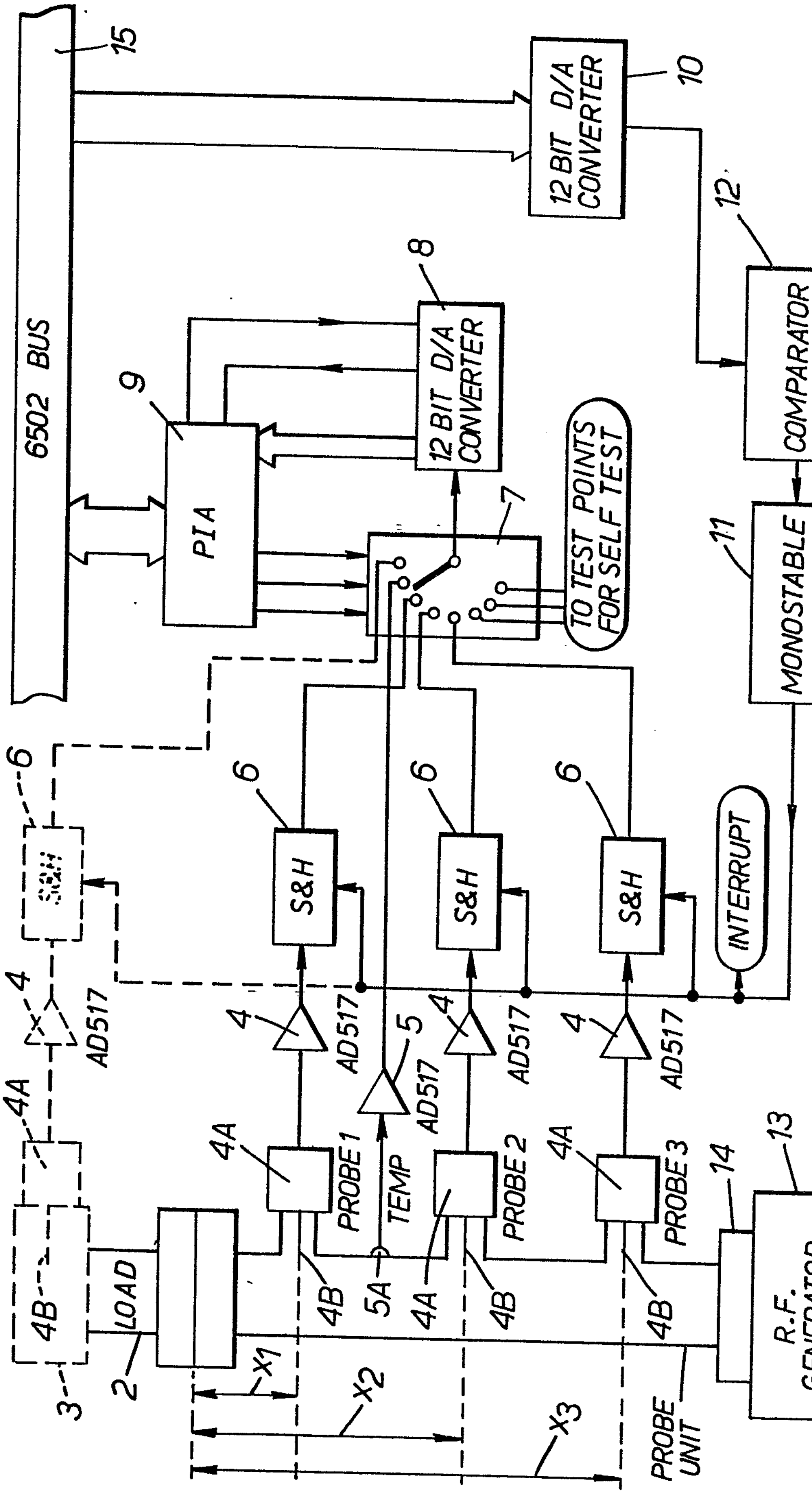


FIG. 1.

0064413

2/8

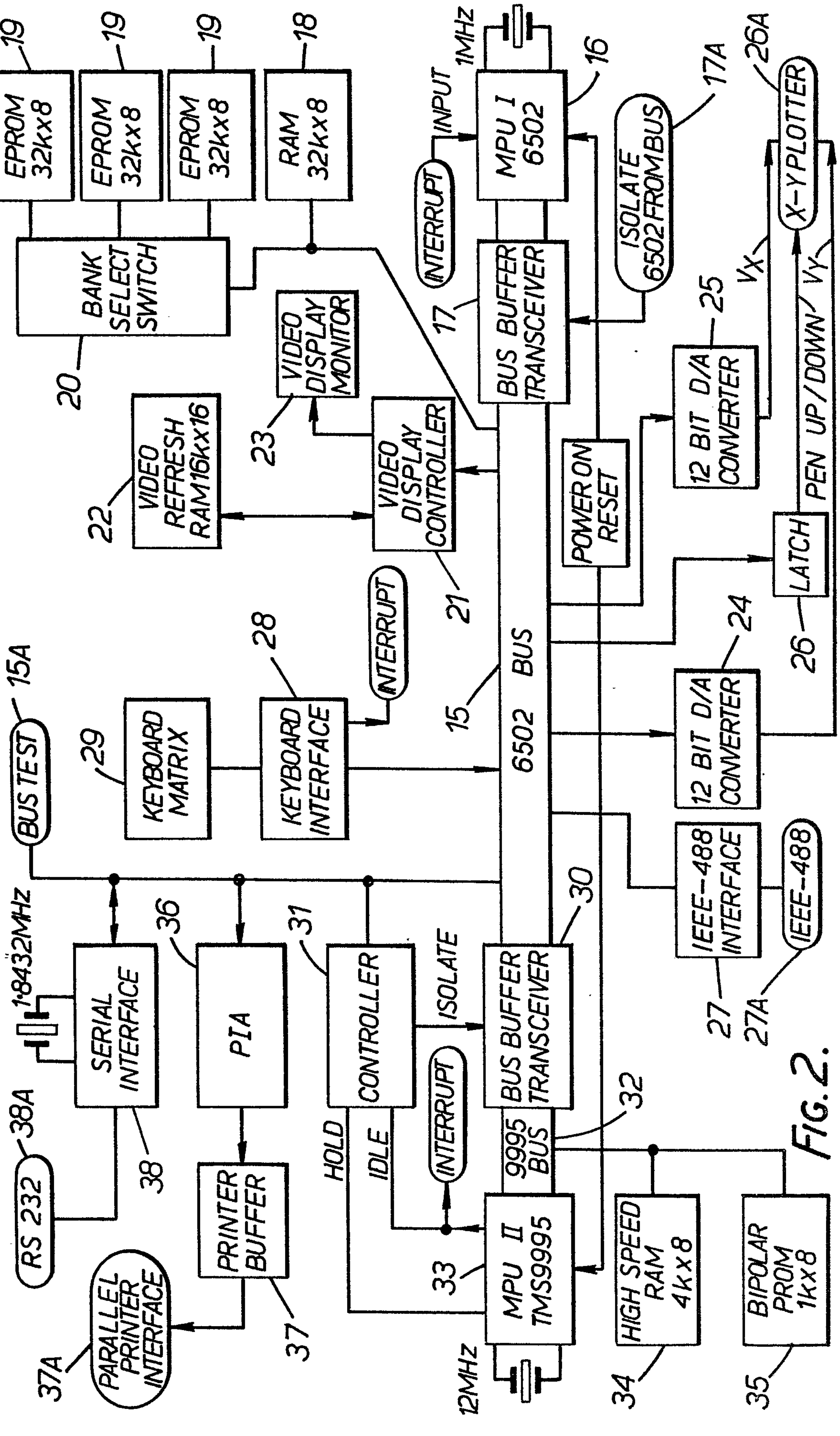


FIG. 2.

0064413

3/8

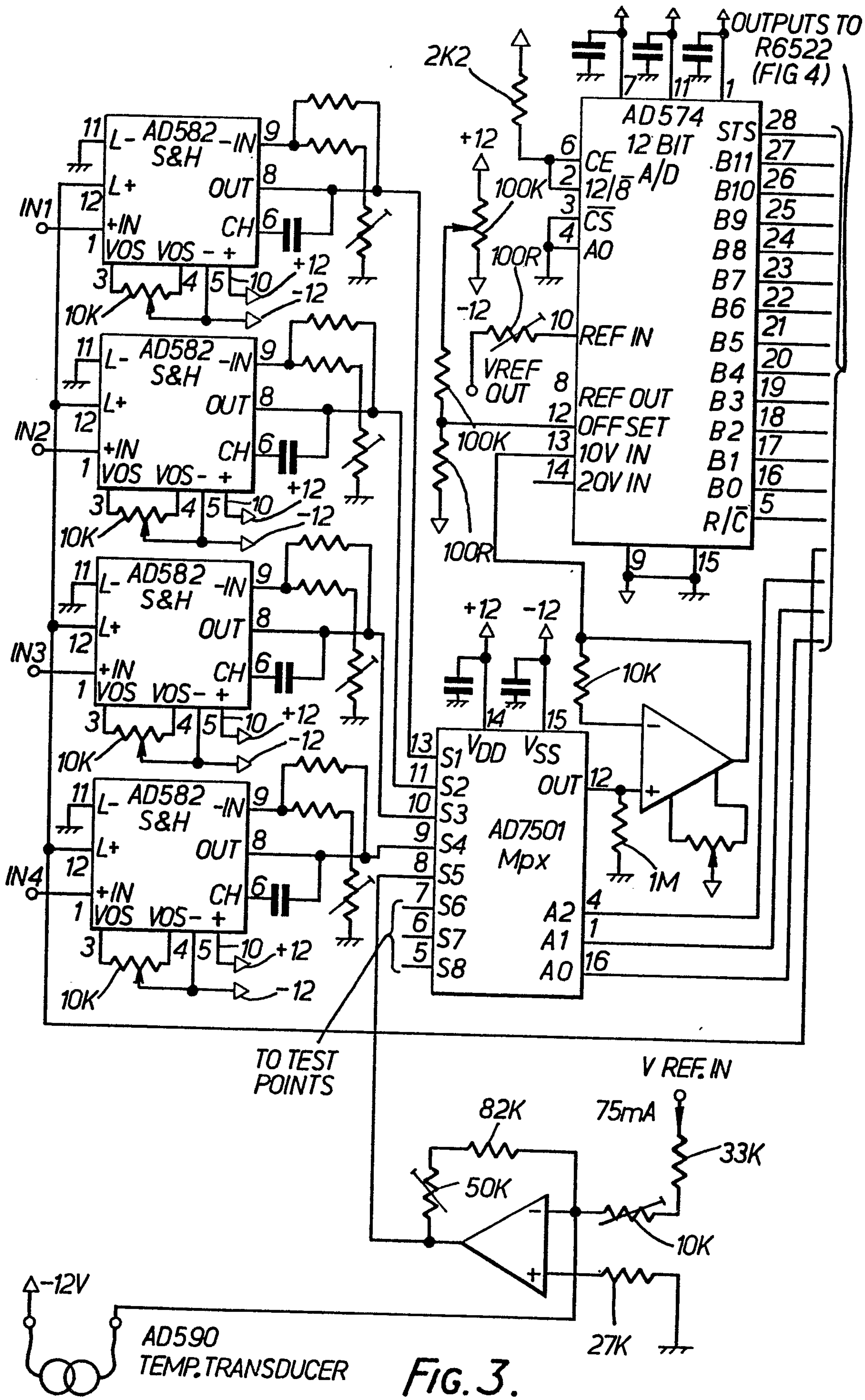


FIG. 3.

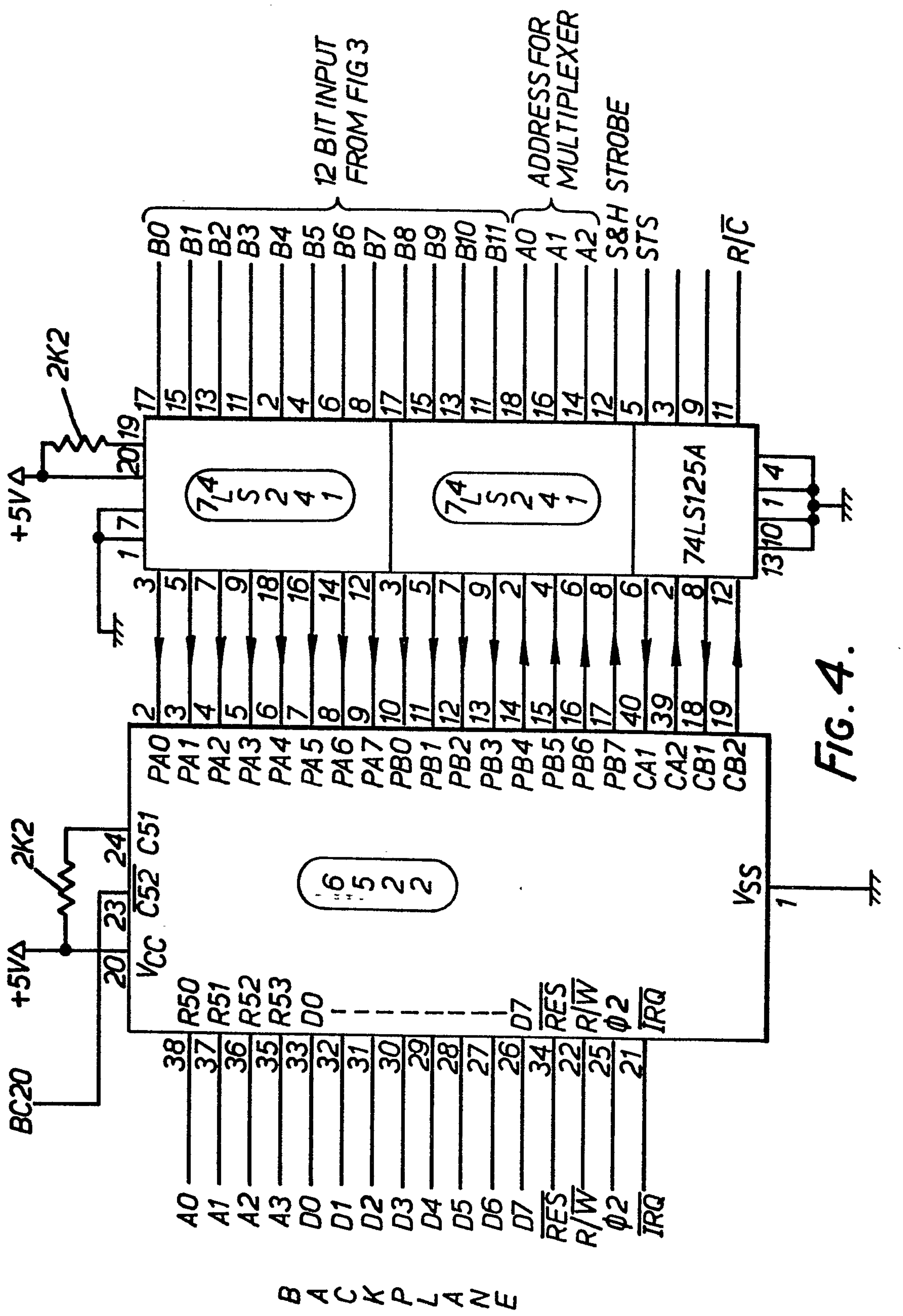
12 BIT INPUT FROM FIG 3
ADDRESS FOR MULTIPLEXER
S&H STROBE
STS
R/C
B0 B1 B2 B3 B4 B5 B6 B7 B8 B9 B10 B11
A0 A1 A2
2K2
+5V
74LS241
74LS241
74LS125A
6522
PA0 PA1 PA2 PA3 PA4 PA5 PA6 PA7 PB0 PB1 PB2 PB3 PB4 PB5 PB6 PB7 CA1 CA2 CB1 CB2
VCC C52 C51 VSS
R50 R51 R52 R53 D0 D7 RES R/W φ2 IRQ
BC20
A0 A1 A2 A3 D0 D1 D2 D3 D4 D5 D6 D7 RES R/W φ2 IRQ
BACKPLANE

FIG. 4.

| ADD | S1 | 2 | 3 | 4 |
|---|---|---|---|---|
| 0000 | | X | X | |
| 4000 | | X | | X |
| 8000 | X | | X | |
| C000 | X | | | X |

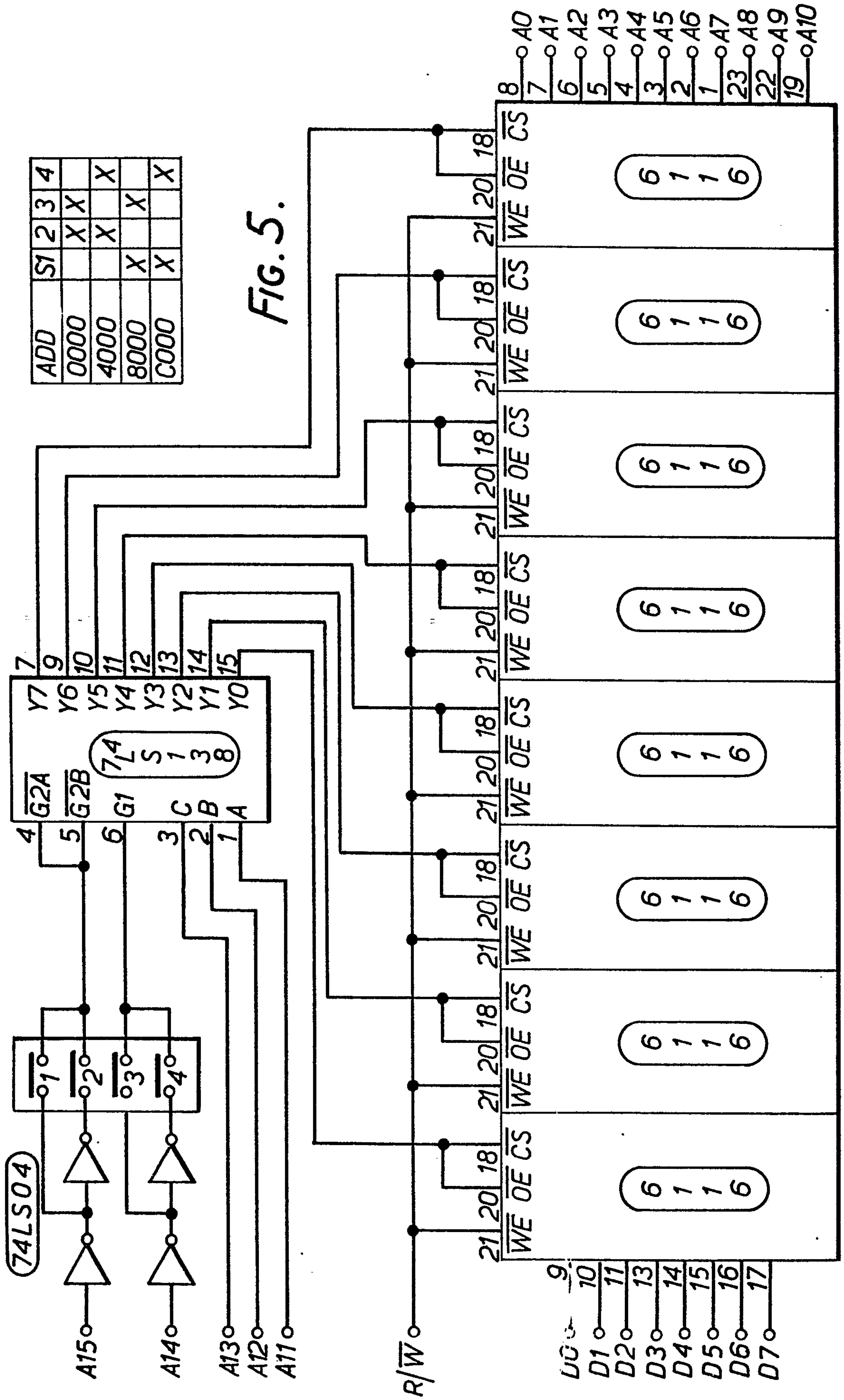


FIG. 5.

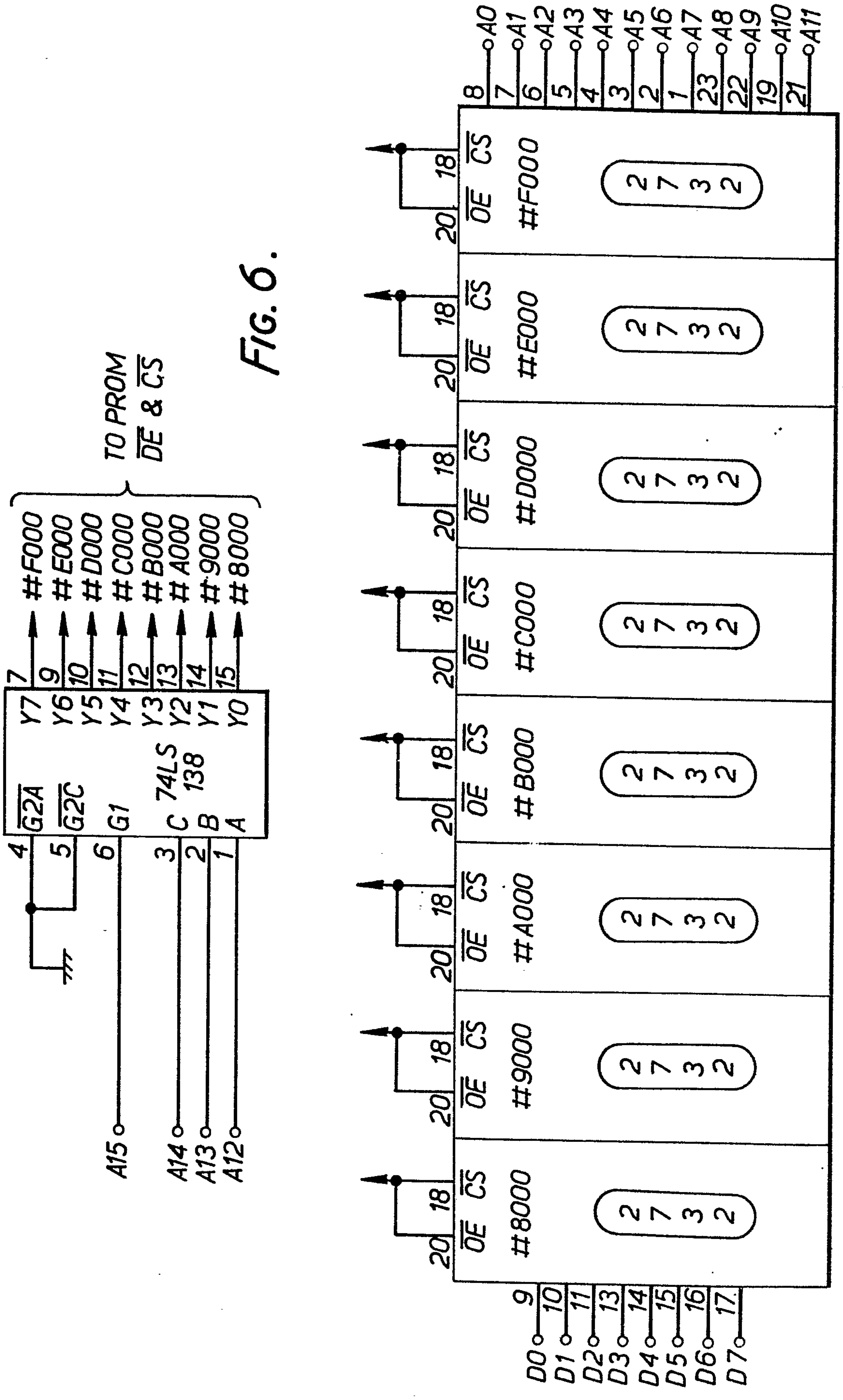

A0
A1
A2
A3
A4
A5
A6
A7
A8
A9
A10
A11
D0
D1
D2
D3
D4
D5
D6
D7
A15
A14
A13
A12
74LS 138
G2A
G2C
G1
C
B
A
Y7
Y6
Y5
Y4
Y3
Y2
Y1
Y0
#F000
#E000
#D000
#C000
#B000
#A000
#9000
#8000
TO PROM OE & CS
OE
CS
2732


FIG. 6.

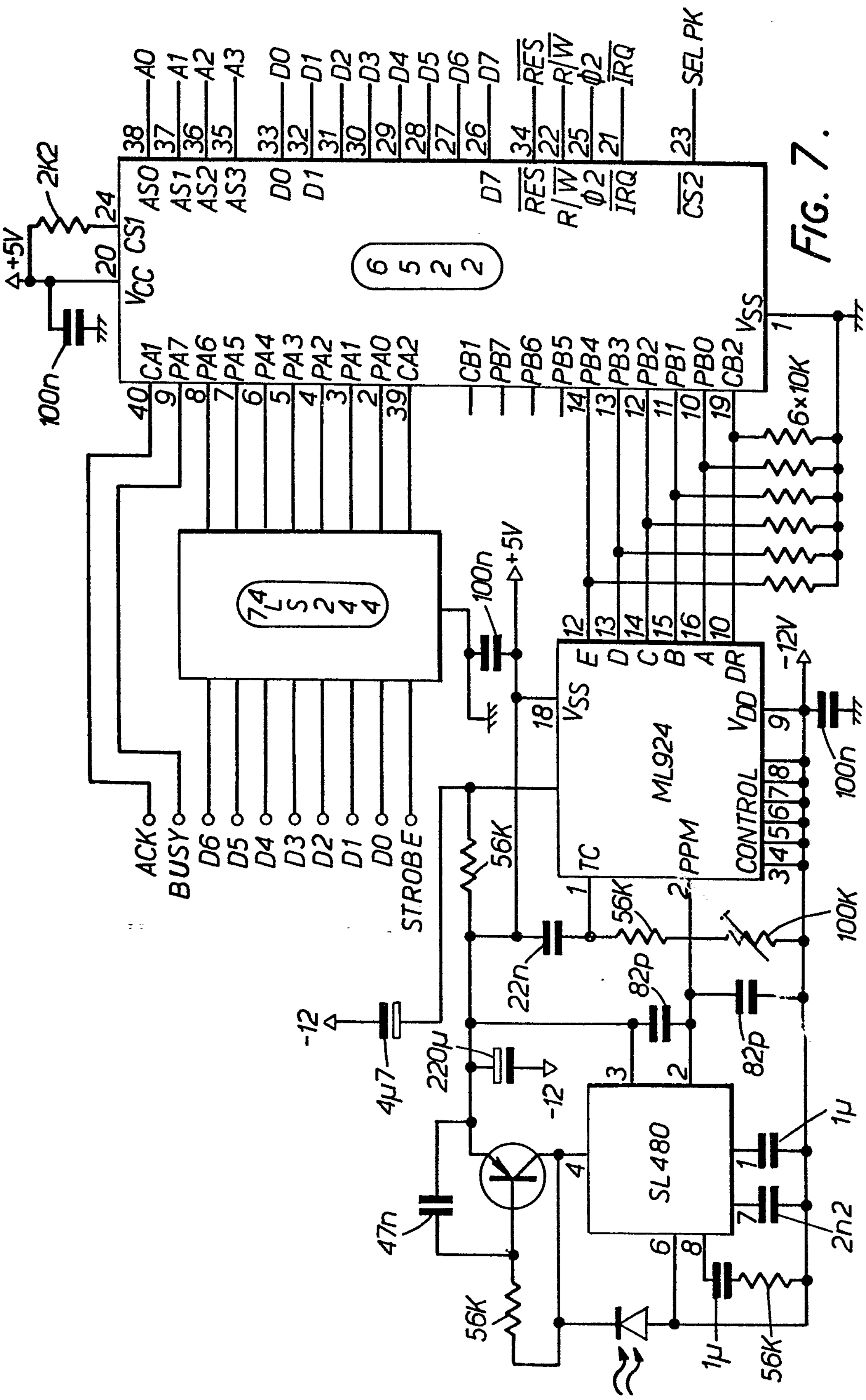
6522
74LS244
ML924
SL480
AO A1 A2 A3 D0 D1 D2 D3 D4 D5 D6 D7
RES R/W ϕ2 IRQ SEL PK
ASO AS1 AS2 AS3 CS1 CS2 VCC VSS
CA1 PA7 PA6 PA5 PA4 PA3 PA2 PA1 PA0 CA2 CB1 PB7 PB6 PB5 PB4 PB3 PB2 PB1 PB0 CB2
+5V
2K2
100n
6x10K
ACK BUSY D6 D5 D4 D3 D2 D1 D0 STROBE
E D C B A DR
VSS VDD TC PPM CONTROL
-12V
56K
22n
82p
100K
4µ7
220µ
-12
47n
1µ
2n2

FIG. 7.

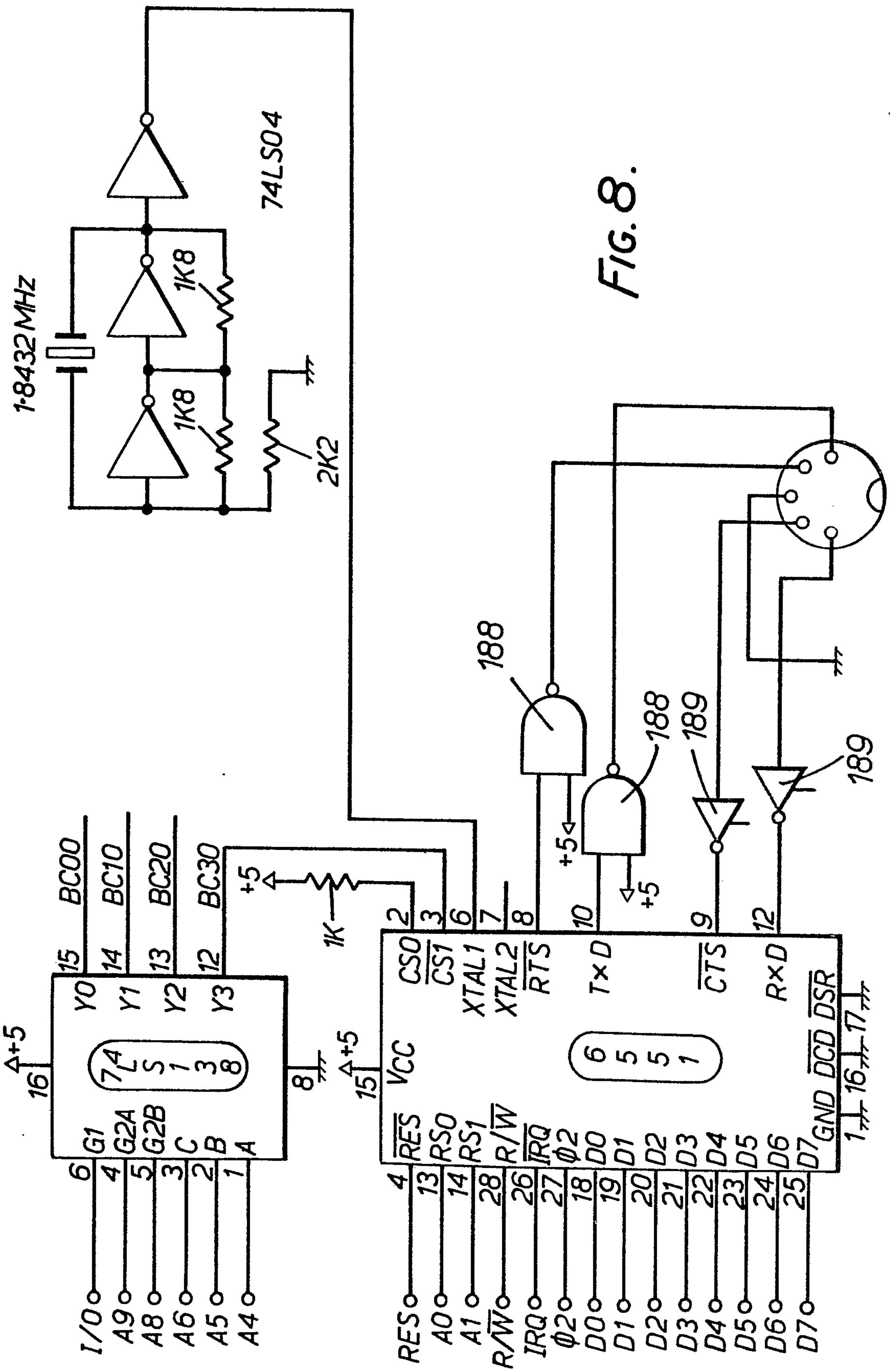

1·8432 MHz
74LS04
1K8
1K8
2K2
188
188
189
189
+5
1K
74LS138
BC00
BC10
BC20
BC30
Y0
Y1
Y2
Y3
G1
G2A
G2B
C
B
A
I/O
A9
A8
A6
A5
A4
6551
VCC
CS0
CS1
XTAL1
XTAL2
RTS
T×D
CTS
R×D
DSR
DCD
GND
RES
RS0
RS1
R/W
IRQ
ϕ2
D0
D1
D2
D3
D4
D5
D6
D7
A0
A1


FIG. 8.

0064413

European Patent Office

# EUROPEAN SEARCH REPORT

Application number

EP 82 30 2296

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | IEEE TRANSACTIONS ON MICROWAVE THEORY AND TECHNIQUES, vol. MTT-28, no. 12, December 1980, pages 1422-1428, New York (USA); CHIA-LUN J.HU: "A novel approach to the design of multiple-probe high-power microwave automatic impedance measuring schemes". *Page 1427, column 2, lines 3-22* --- | 1 | G 01 R 27/04 |
| A | IEEE TRANSACTIONS ON MICROWAVE THEORY AND TECHNIQUES, vol. MTT-27, no. 1, January 1979, pages 38-43, New York (USA); CHIA-LUN J.HU: "Online measurements of the fast changing dielectric constant in oil shale due to high-power microwave heating". *Figure 8* --- | 1 | TECHNICAL FIELDS SEARCHED (Int. Cl. ³) |
| A | GB-A- 908 387 (GENERAL ELECTRIC) *The whole document* ----- | | G 01 R |

The present search report has been drawn up for all claims

| Place of search | Date of completion of the search | Examiner |
|---|---|---|
| THE HAGUE | 16-07-1982 | KORAHNKE G.J. |

CATEGORY OF CITED DOCUMENTS

X : particularly relevant if taken alone
Y : particularly relevant if combined with another document of the same category
A : technological background
O : non-written disclosure
P : intermediate document
T : theory or principle underlying the invention
E : earlier patent document, but published on, or after the filing date
D : document cited in the application
L : document cited for other reasons
& : member of the same patent family, corresponding document

EPO Form 1503. 03.82